(19) Europäisches Patentamt

European Patent Office

Office européen des brevets

(11) **EP 1 517 334 B1**

(12) **EUROPEAN PATENT SPECIFICATION**

(45) Date of publication and mention
of the grant of the patent:
**27.10.2010 Bulletin 2010/43**

(51) Int Cl.:
***G11C 29/00*** (2006.01)

(21) Application number: **03292283.3**

(22) Date of filing: **16.09.2003**

(54) **On-chip diagnosis method and on-chip diagnosis block for memory repair with mixed redundancy (IO redundancy and word-register redundancy)**

On-chip Diagnose-Vefahren und -Block zur Speicherreparatur mit gemischter Redundanz ("IO" Redundanz und "Word-register" Redundanz)

Méthode et bloc de diagnostic sur puce pour réparation d'une mémoire avec redondance mixte ("IO" et "Word-register" redondance)

(84) Designated Contracting States:
**DE FR GB**

(43) Date of publication of application:
**23.03.2005 Bulletin 2005/12**

(73) Proprietor: **Infineon Technologies AG**
**85579 Neubiberg (DE)**

(72) Inventors:
• **Jallamion-Grive, Yannis**
**06250 Mougins (FR)**
• **Collura, Michel**
**83300 Draguignan (FR)**
• **Vial, Jean-Christophe**
**06600 Antibes (FR)**

(74) Representative: **Lange, Thomas et al**
**Patentanwälte**
**Lambsdorff & Lange**
**Dingolfinger Strasse 6**
**81673 München (DE)**

(56) References cited:
**US-A- 5 469 390      US-A- 5 910 921**
**US-A- 6 065 134      US-A- 6 141 267**
**US-A1- 2002 108 073   US-B1- 6 304 989**
**US-B1- 6 502 216**

• **"BEST SOLUTION GENERATOR FOR REDUNDANCY" IBM TECHNICAL DISCLOSURE BULLETIN, IBM CORP. NEW YORK, US, vol. 29, no. 6, 1 November 1986 (1986-11-01), pages 2756-2758, XP000715549 ISSN: 0018-8689**
• **AKIRA TANABE ET AL: 'A 30-NS 64-MB DRAM WITH BUILT-IN SELF-TEST AND SELF-REPAIR FUNCTION' IEEE JOURNAL OF SOLID-STATE CIRCUITS. 01 November 1992, USIEEE INC. NEW YORK., XP000320438**

**Description**

The invention relates to diagnosis and repair of defects at memories on chips. In particular the invention relates to an on chip diagnosis method and to an on chip diagnosis block.

Memories are much denser than any logic. Since many bits need to be packed as tightly as possible, defects are part of any fabrication process. In order to avoid these defects and increase the yield, most memories have redundancy: internal redundancy (IO or WordLine) or external redundancy (word-register). Since most fails on memories are single cell fails, non-single cell types defects (IO) or cluster of fails. If one wishes to increase the yield to the maximum, then one has to mix all the redundancies available (internal and external).

Several solutions to fix defects inside memories are used according to the state of the art:

- External redundancy only (HDFR from Infineon Technologies): This type of redundancy uses registers to replace failing words. It is well suited for single bit or small cluster fails. However, it is not suitable for BL or IO oriented failures.
- Internal redundancy (WordLine + IO) (MIR-TDR from Infineon Technologies): The main disadvantage is that this solution increases the access & cycle time in the memory block because one has to compare the actual address with the information stored in the fuse boxes. This type of redundancy is well suited for cluster of fails and non-single cell types defects (IO or WordLine defects).
- Words + WordLine + BL redundancy (as described in the European patent application EP 03002698.3 "Memory Built-In Self Repair (MBISR) circuits / devices and method for repairing a memory comprising a Memory Built-In Self Repair (MBISR) structure"; applicant: Infineon Technologies): The main disadvantages of this approach are as follows:

  - more than one BIST (Built-In Self Test) runs are needed (at least three),
  - the usage of redundant wordline implies a lost in performances,
  - the repair solution is hard-coded (first IO/BL, then WordLine, and finally Words),
  - in some cases memories that could be repaired will be discarded, and
  - a first evaluation of the additional logic needed seems that it will be expensive, in particular because a lot of comparisons are performed.

Akira Tanabe, et al. "A 30-ns 64-Mb DRAM with Built-in Self-Test and Self-Repair Function", IEEE Journal of Solid-State Circuits, November 1, 1992, discloses a chip according to the preamble of claim 1 comprising a memory and a MBISR circuit having a plurality of registers which provide for word redundancy. Further, the memory is equipped with redundant rows and columns.

It is an object of the present invention to provide a chip comprising a memory and an on chip diagnosis block for memory repair and an on chip diagnosis method for memory repair, which on chip diagnosis block and which on chip diagnosis method are able to overcome at least part of the disadvantages from the state of the art.

According to the invention this object is achieved by a chip according to claim 1 and by an on chip diagnosis method according to claim 8.

Preferred and advantageous embodiments of the invention are subject matter of the dependent claims.

The idea realised in the present invention allows to improve the yield with a mix of two types of redundancy: external (word-register) and internal redundancy (redundant IO only).

The memories are tested in two steps:

- first one stores (during the BIST run) inside two arrays (one to keep the minimum error mapping and the other one to control the fill of the first one) the main information necessary for the final diagnose (to apply all redundancy resources needed), and
- then one performs the final diagnosis based upon the analysis of the array for keeping the minimum mapping.

The size of the two arrays used is mainly dependent on the size of the redundancy (number of internal redundant IO and external word-register).

The core of the present invention is the way to store (on chip) the defects during the BIST in these two arrays and the way to do (on chip) the diagnosis.

The invention provides the following advantages:

- It finds a good compromise to repair several types of defects and hence to increase yield.
- Diagnosis is done "On Chip", i.e. there is no need to do an external analysis. Therefore less time is needed for testing the chip.
- Diagnostic of the best repair solution is very fast.

- The number of additional gates needed to analyse errors is very small compared to method known from the state of the art.
- There is no impact on timings compared to a memory with internal redundant IO and WordLine.
- Only one BIST run is needed.
- Both IO and word-registers repair solutions are evaluated at the time.
- All fixable memories will be repaired, i.e. there is no possibility that fixable memories will be discarded.
- Independency from the architecture of the memory.
- Independency from the BIST algorithm.
- Independency from the kind of memory: SRAM, DRAM, CAM.

Once all failures are detected in a memory, the present invention allows to do easily a fast diagnosis in order to propose the best repair solution even if there are several types of defects (single, IO, cluster).

Examples of preferred and advantageous embodiments of the invention will now be described herein below with reference to the accompanying drawings in which

Fig. 1          is a schematic view of an embodiment of the invention with respect to an SRAM 4kx32,

Fig. 2          shows an example of a failure with respect to the SRAM of Fig. 1,

Fig. 3          shows an example of a fill_array and of a shift_array, respectively,

Figs. 4 to 13   show in a detailed view how, according to one embodiment of the method according to the invention, to fill the arrays of Fig. 3 during diagnosis of the failure shown in Fig. 2,

Fig. 14         shows how a reference element is built from the fill_array at the end of a BIST run,

Fig. 15         shows how difference elements are built from the reference element and the fill_array,

Fig. 16         shows how the redundant IO is fixed using the difference elements shown in Fig. 15, and

Fig. 17         is a flow chart of a test repair sequence.

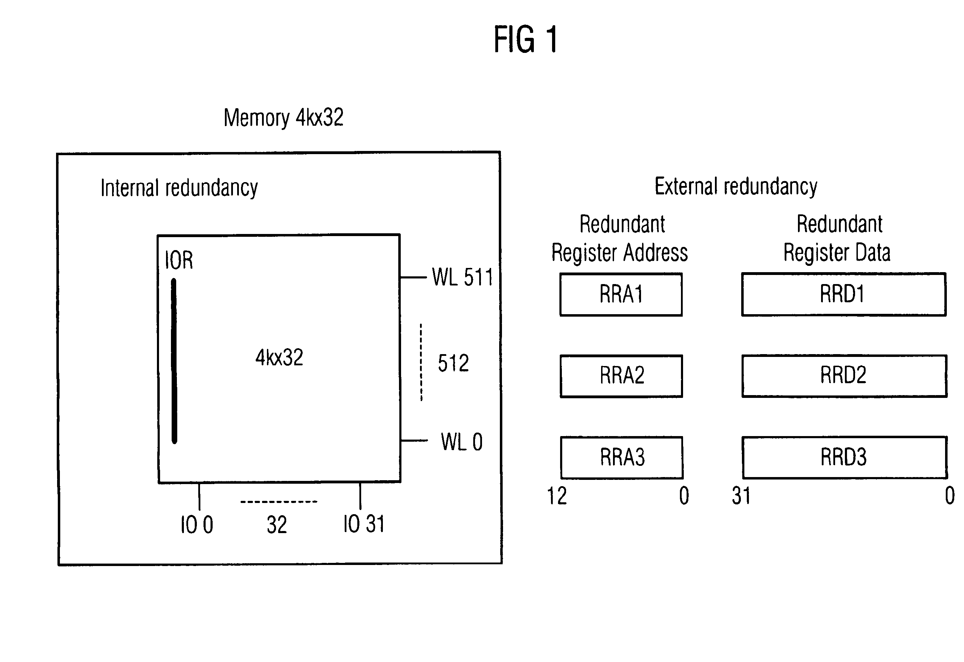

An embodiment of the invention will now be described with respect to an SRAM 4kx32 with 1 redundant IO and 3 redundant registers. Such an SRAM embodying an on chip diagnosis block according to the invention is shown in Fig. 1. As can be seen, the word-register redundancy is carried out as external redundancy, and internal redundancy is the redundant IO only. Summarizing, the available redundancy of the embodiment shown in Fig. 1 consists of one complete redundant IO (IOR) inside the memory, and three redundant register addresses.

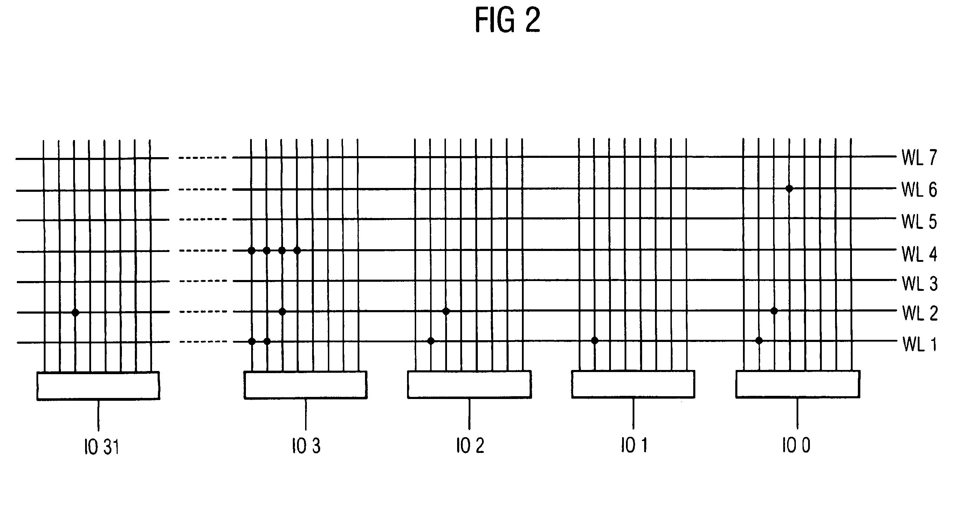

Fig. 2 shows an example of a failure in the SRAM of Fig. 1, which failure is repairable with the available redundancy.

During a BIST run all these errors are produced. It has to be noted that some errors are produced several times, depending on the state of the BIST. Single error or multiple errors on the same word are possible.

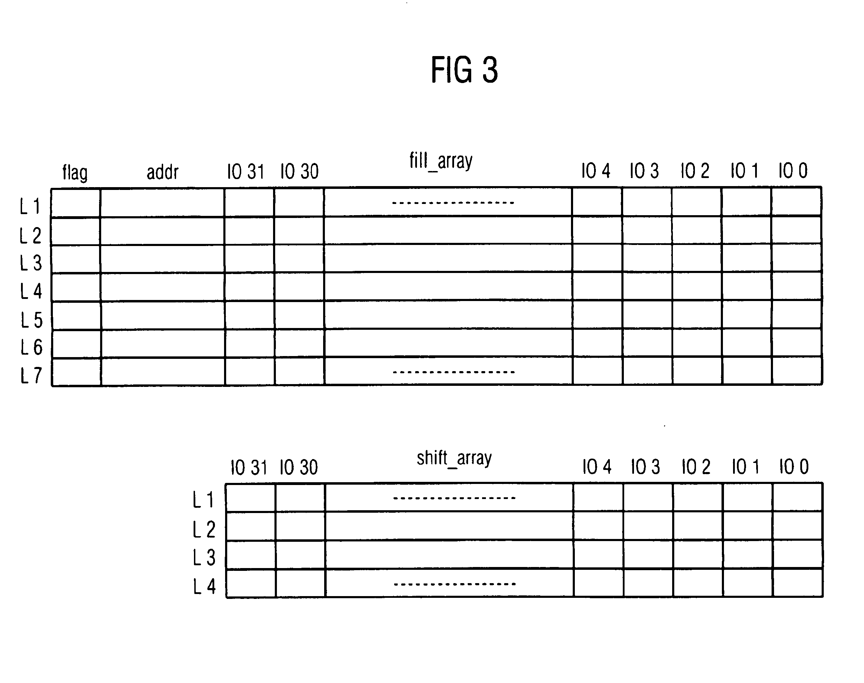

The on chip diagnosis block according to the invention comprises two mandatory arrays ("fill_array" and "shift_array"). Examples for both arrays are shown in Fig. 3.

The size of the fill_array is defined by the total size of available redundancy. At the present example there are 1 redundant IO and 3 redundant word registers. The number of lines is defined by:

$$2*(3 \text{ redundant registers}) + 1 \text{ redundant IO} = 7 \text{ lines}$$

The size of the shift_array depends on the number of redundant registers:

$$3 \text{ redundant registers} + 1 = 4 \text{ lines}$$

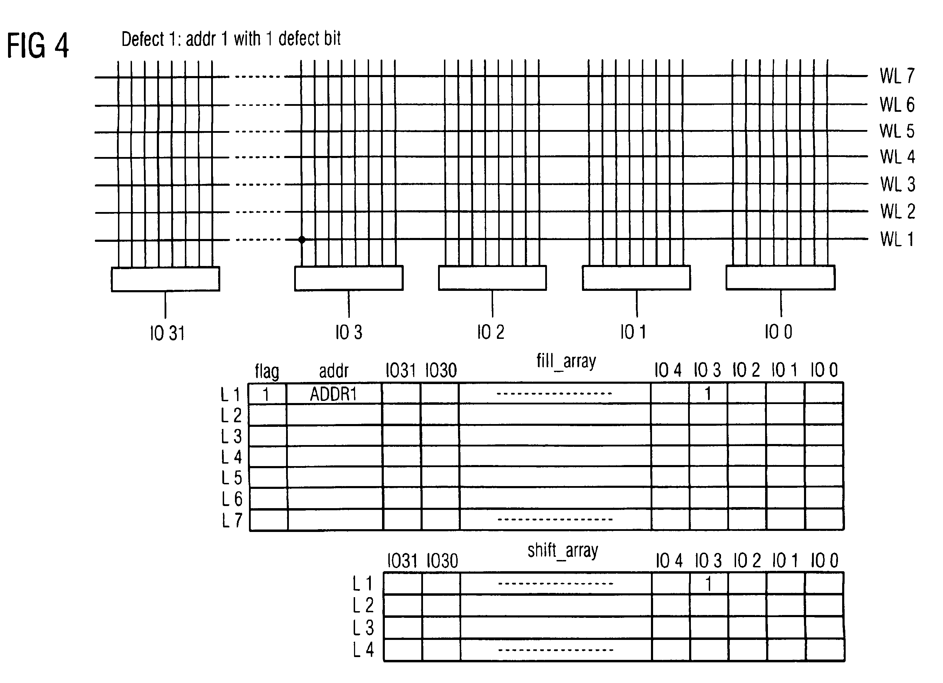

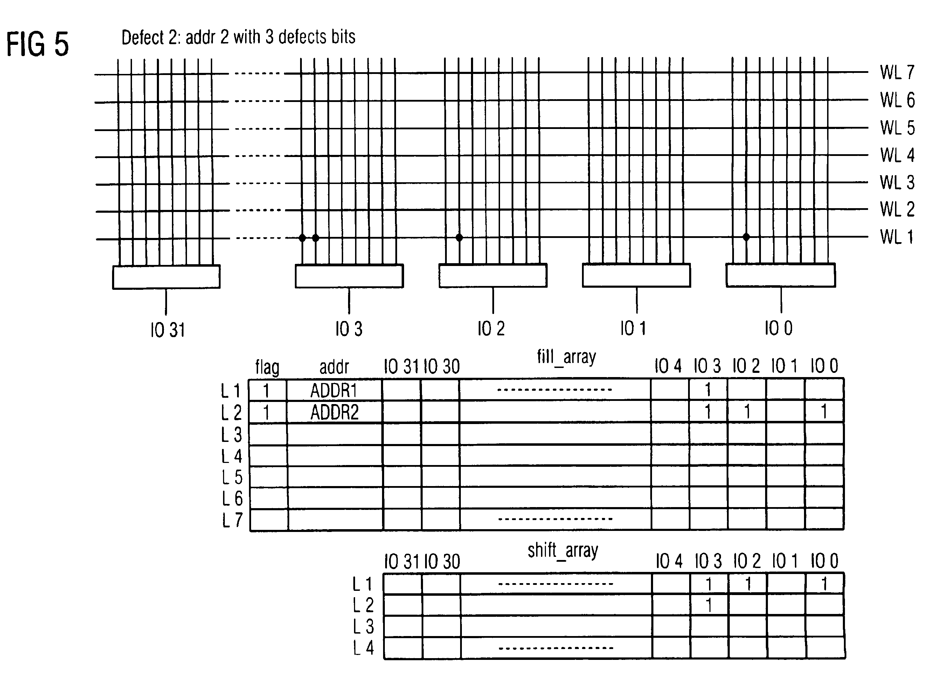

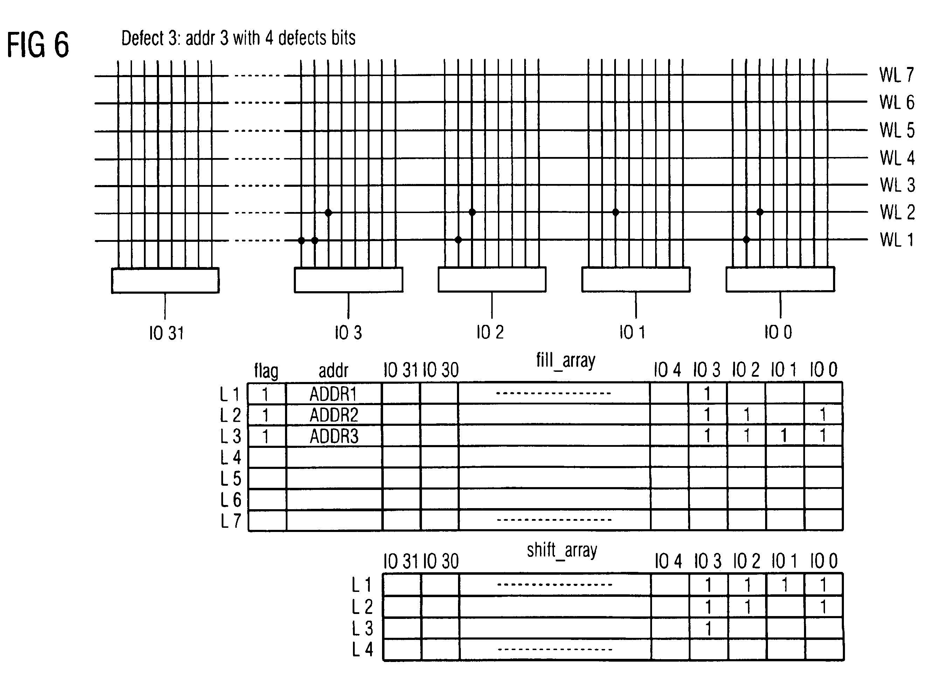

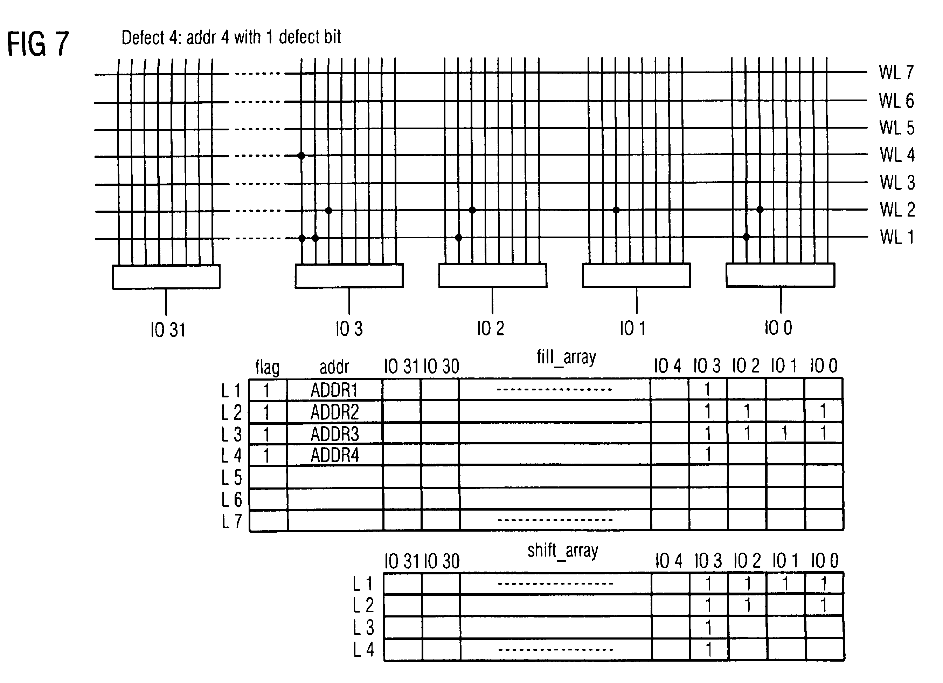

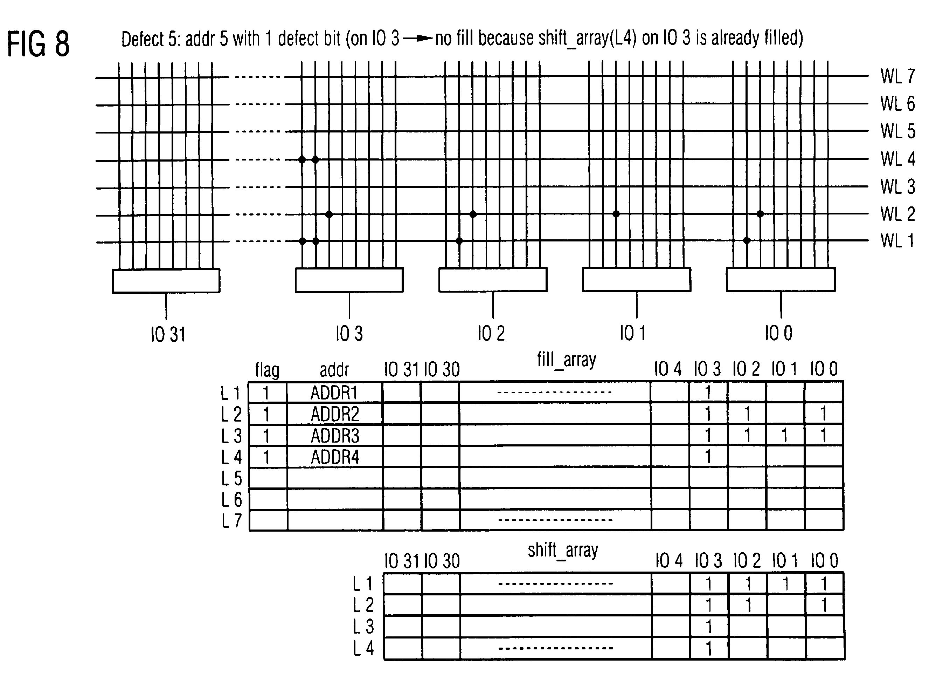

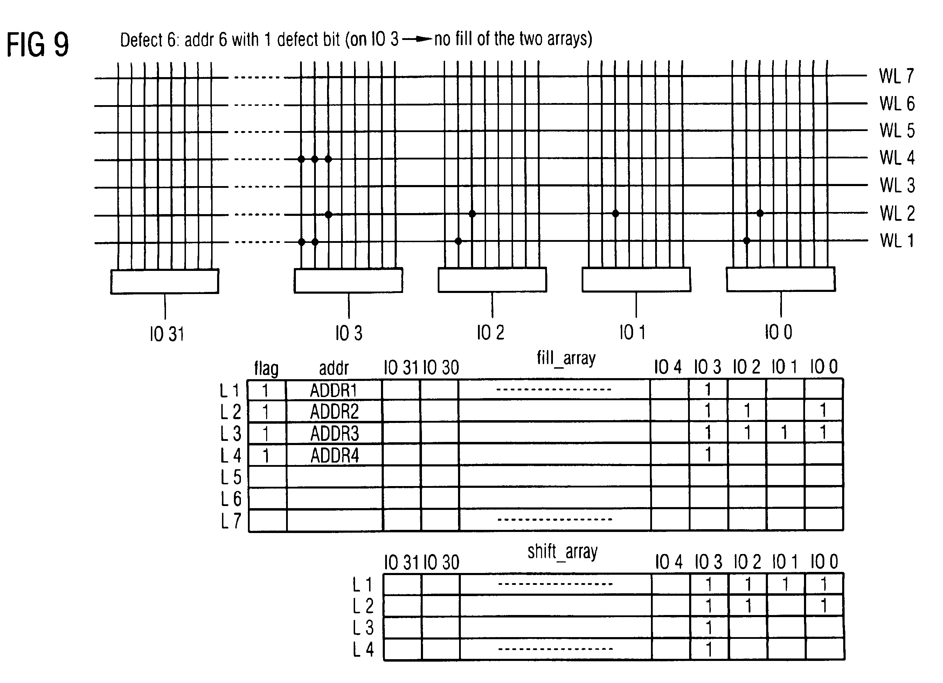

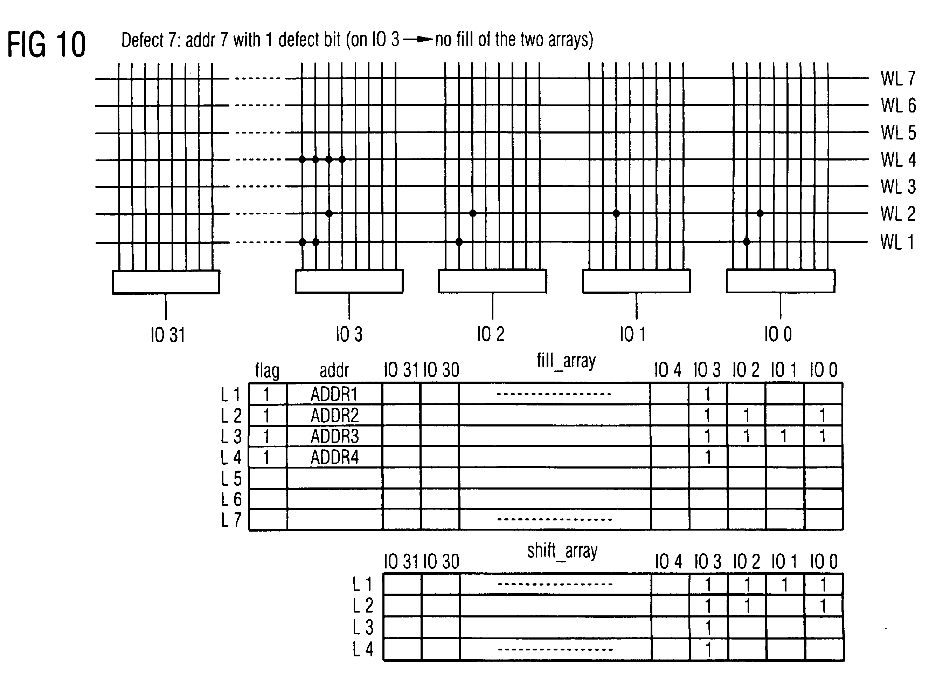

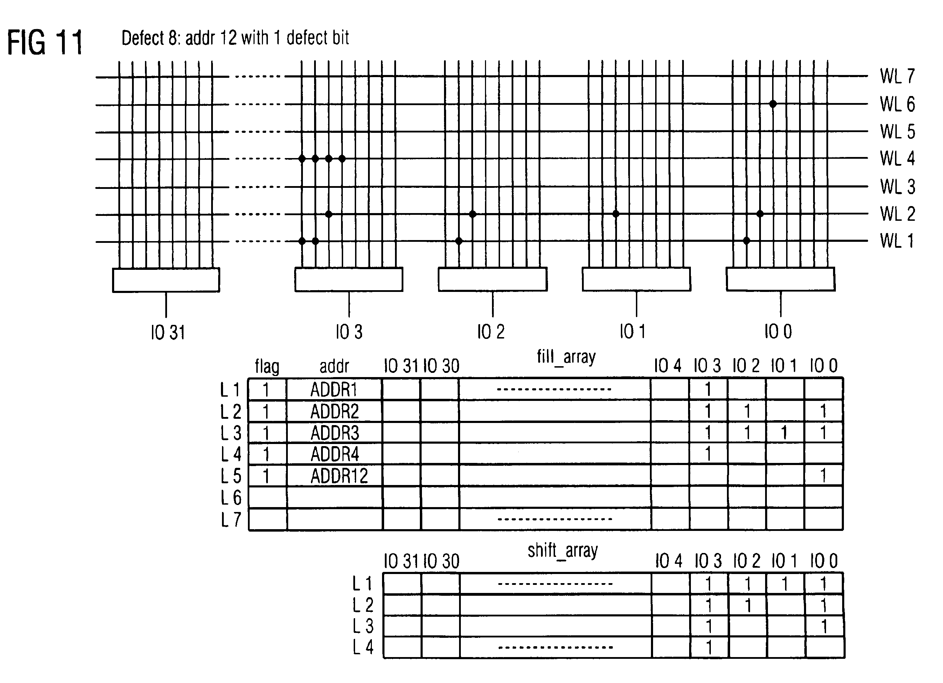

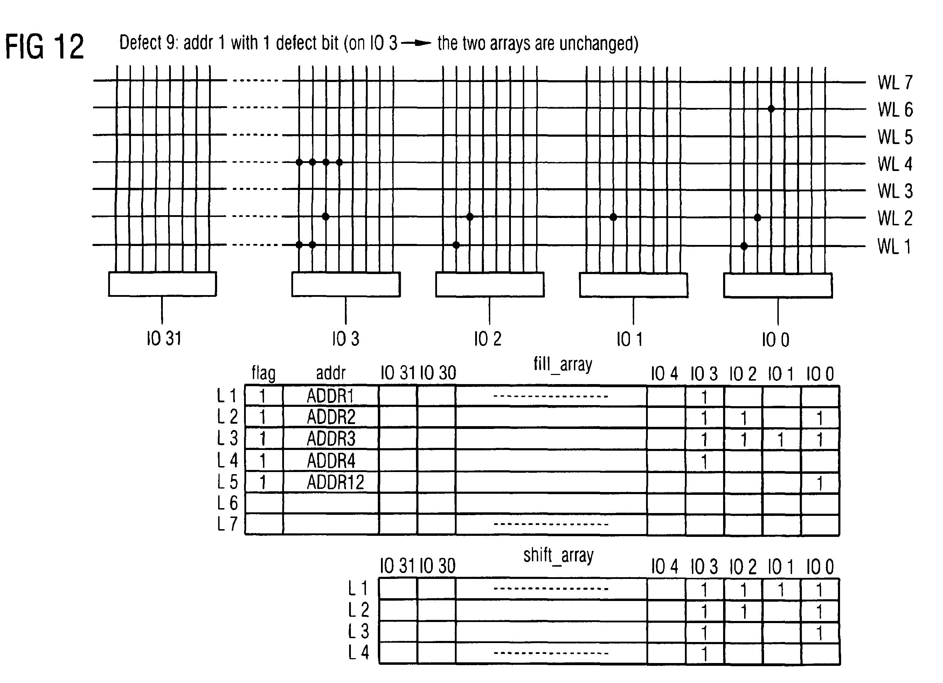

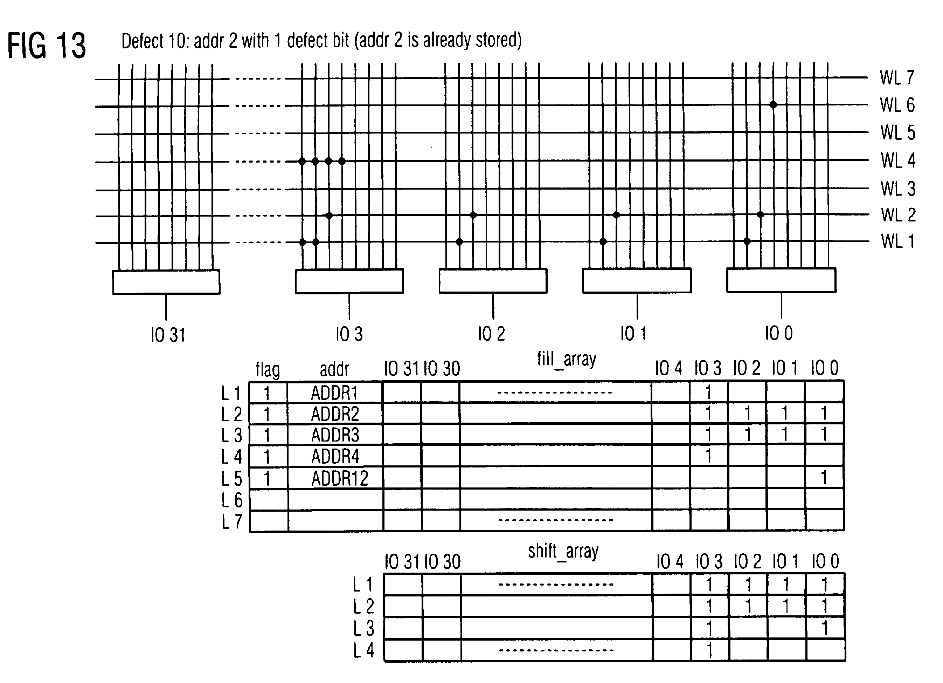

With respect to the SRAM of Fig. 1 comprising the failure shown in Fig. 2 the Figs. 4 to 13 show in a detailed view how to fill the two mandatory arrays (fill_array, shift_array) for diagnosis according to one embodiment of an on chip diagnosis method according to the invention. It has to mentioned once again that according to the invention the defects are stored on chip during BIST and the diagnosis is carried out on chip, too, using said two arrays (fill_array, shift_array).

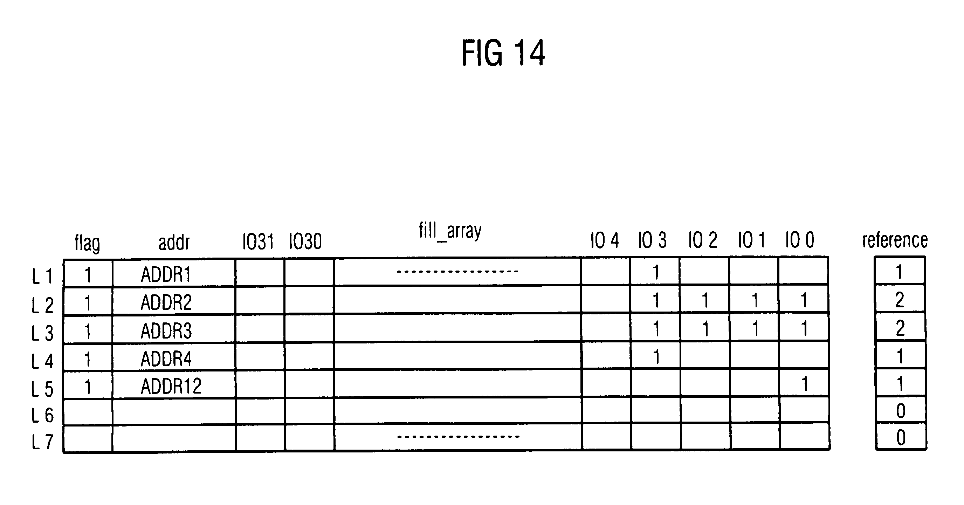

At the end of the BIST run for the diagnostic there are built two elements from the fill_array. The first one is called "reference element" (cf. Fig. 14). The reference element indicates for each line of the fill_array if there is one or more than one fault for each address stored.

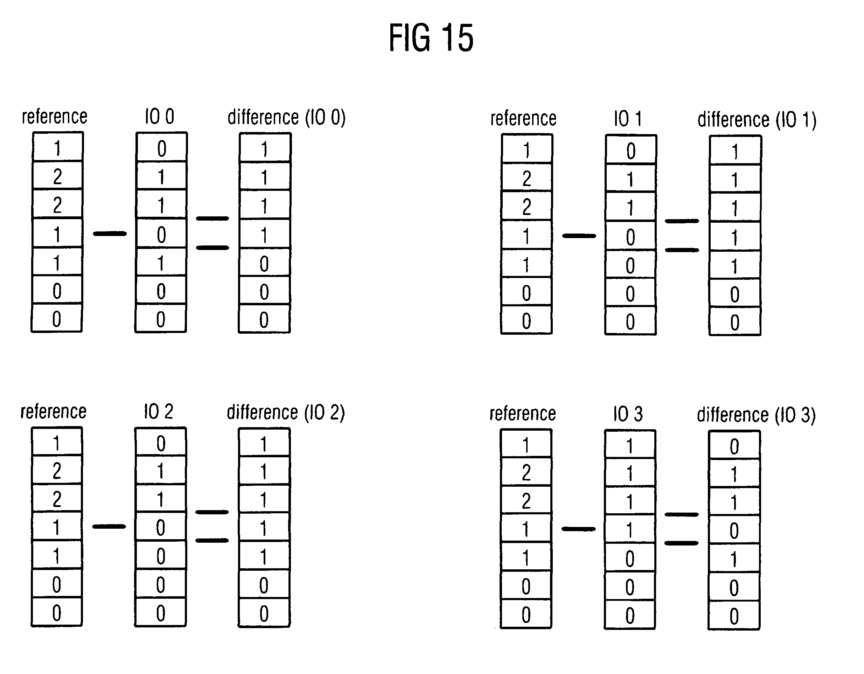

The second element (called "difference element") computes for each IO the difference between the reference element and the "fill_array(IO xx)" (cf. Fig. 15).

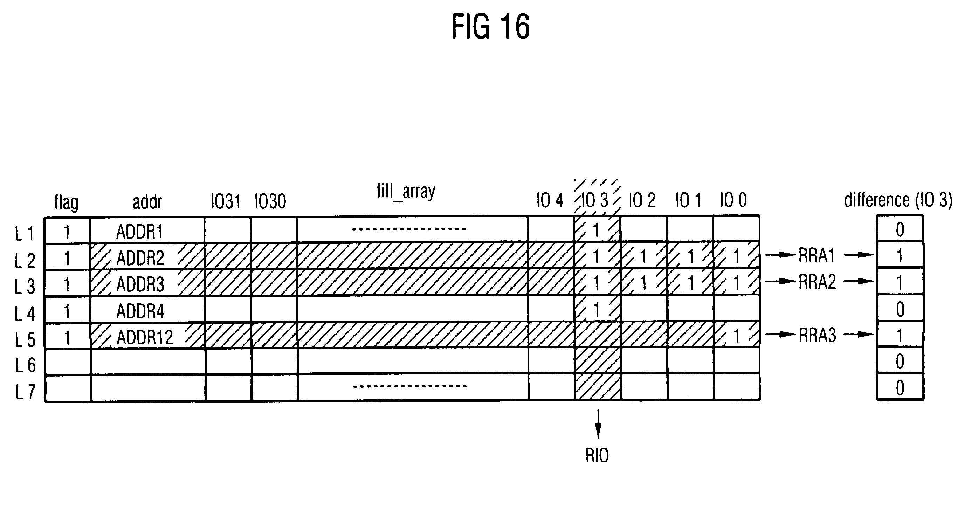

To fix the redundant IO it is checked which difference element has the maximum number of "0". In the present example the maximum number of "0" is inside difference (IO 3) = 4. The memory of Fig. 1 can now be repaired by replacing I03 with the redundant IO (IOR) (cf. Fig. 16). The element "difference (IO3)" idnicates which addresses have to be stored inside redundant registers (inside this element it is indicated by all bits set to "1"). So one can activate the external redundancy by RRA1 = ADDR2, RRA2 = ADDR3, and RRA3 = ADDR12.

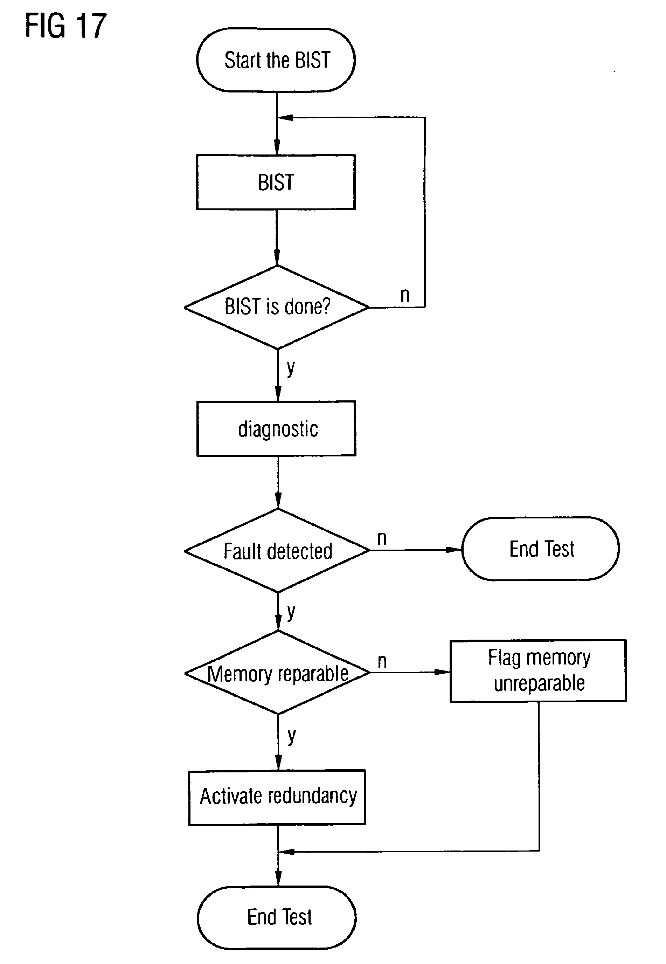

Summarizing, Fig. 17 shows a flow chart of the test repair sequence.

## Claims

1. A chip comprising a memory and an on chip diagnosis block for memory repair, the memory comprises a plurality of groups of memory cells wherein each group is associated with an IO of the memory, the chip further comprises a plurality of redundant word-registers external to the memory; **characterised in that**

   the memory further comprises a redundant group of memory cells being associated with a redundant IO of the memory, wherein such IO redundancy is the only redundancy internal to the memory, and
   the on chip diagnosis block is arranged to store during a BIST run defect information and to perform a final diagnosis on chip based upon an analysis of said information to evaluate both IO and word-registers repair solutions.

2. The chip according to claim 1, wherein
   the on chip diagnosis block for memory repair comprises a first array (fill_array) and a second array (shift_array) on chip and is configured to use the second array (shift_array) to control the fill of the first array (fill_array) during the BIST.

3. The chip according to claim 2, wherein
   the on chip diagnosis block for memory repair is arranged to perform said final diagnosis upon an analysis of the first array (fill_array).

4. The chip according to claim 3, wherein
   the on chip diagnosis block for memory repair is configured such that at the end of the BIST
   a reference element is formed from said first array (fill_array), which reference element indicates for each row of the first array (fill_array) if there are one or more than one defect bits for each stored address of a memory word, difference elements (IO 0, IO 1, IO 2, IO 3) are formed, which difference elements (IO 0, IO 1, IO 2, IO 3) indicate for each IO of the memory the difference between said reference element and a column in the first array (shift_array) corresponding to the respective IO of the memory,
   the difference element (IO 3) with the maximum number of zero entry values is selected to indicate which IO of the memory is to be replaced by the redundant IO of the memory.

5. The chip according to claim 4, wherein
   the on chip diagnosis block for memory repair is configured such that the selected difference element (IO 3) indicates which addresses of memory words are to be stored inside the redundant word-registers external to the memory.

6. The chip according to claims 2 to 5, wherein
   the size of the first array (fill_array) is defined by: number of rows of the first array (fill_array) = 2*(number of redundant word-registers) + number of redundant IOs of the memory.

7. The chip according to claims 2 to 6, wherein
   the size of the second array (shift_array) is defined by: number of rows of the second array (shift_array) = number of the redundant word-registers + number of the redundant IOs of the memory.

**8.** An on chip diagnosis method for memory repair, the memory comprises a plurality of groups of memory cells wherein each group is associated with an IO of the memory, the memory further comprises a redundant group of memory cells being associated with a redundant IO of the memory, wherein such IO redundancy being the only redundancy internal to the memory, and the chip comprises an on chip diagnosis block and a plurality of redundant word-registers external to the memory, comprising the steps:

- during a BIST run storing defect information in the on chip diagnosis block, and then
- the on chip diagnosis block performing a final diagnosis on chip based upon an analysis of said information to evaluate both IO and word-registers repair solutions.

**9.** The on chip diagnosis method according to claim 8, further comprising:

using a second array (shift_array) comprised in the on chip diagnosis block for memory repair to control the fill of a first array (fill_array) comprised in the on chip diagnosis block for memory repair during the BIST.

**10.** The on chip diagnosis method according to claim 9, further comprising:

analysing the first array (fill_array) to perform said final diagnosis.

**11.** The on chip diagnosis method according to claim 10, further comprising:

generating a reference element from said first array (fill_array), which reference element indicates for each row of the first array (fill_array) if there are one or more than one defect bits for each stored address of a memory word, generating difference elements (IO 0, IO 1, IO 2, IO 3), which difference elements (IO 0, IO 1, IO 2, IO 3) indicate for each IO of the memory the difference between said reference element and a column in the first array (shift_array) corresponding to the respective IO of the memory, and selecting the difference element (IO 3) with the maximum number of zero entry values to indicate which IO of the memory is to be replaced by the redundant IO of the memory.

**12.** The on chip diagnosis method according to claim 11, further comprising:

deciding which addresses of memory words are to be stored inside the word-registers external to the memory on the basis of the selected difference element (IO 3).

**13.** The on chip diagnosis method according to claims 8 to 12, wherein only one BIST run is performed.


**Patentansprüche**

**1.** Chip mit einem Speicher und einem On-Chip-Diagnoseblock zur Speicherreparatur, wobei der Speicher eine Vielzahl von Gruppen von Speicherzellen umfasst und jede Gruppe mit einer IO des Speichers assoziiert ist, wobei der Chip ferner eine Vielzahl von redundanten Wortregistern außerhalb des Speichers umfasst; **dadurch gekennzeichnet, dass**
der Speicher ferner eine redundante Gruppe von Speicherzellen umfasst, die mit einer redundanten IO des Speichers assoziiert ist, wobei solche IO-Redundanz die einzige Redundanz innerhalb des Speichers ist, und der On-Chip-Diagnoseblock dafür ausgelegt ist, während eines BIST-Durchlaufs Defektinformationen zu speichern und auf der Basis einer Analyse der Informationen eine Enddiagnose auf dem Chip durchzuführen, um sowohl IOals auch Wortregister-Reparaturlösungen zu evaluieren.

**2.** Chip nach Anspruch 1, wobei
der On-Chip-Diagnoseblock zur Speicherreparatur ein erstes Array (fill_array) und ein zweites Array (shift_array) auf dem Chip umfasst und dafür ausgelegt ist, das zweite Array (shift_array) zur Steuerung des Füllens des ersten Arrays (fill_array) während des BIST zu verwenden.

**3.** Chip nach Anspruch 2, wobei
der On-Chip-Diagnoseblock zur Speicherreparatur dafür ausgelegt ist, die Enddiagnose auf eine Analyse des ersten Arrays (fill_array) hin durchzuführen.

**4.** Chip nach Anspruch 3, wobei
der On-Chip-Diagnoseblock zur Speicherreparatur so konfiguriert ist, dass am Ende des BIST
ein Referenzelement aus dem ersten Array (fill_array) gebildet wird, wobei dieses Referenzelement für jede Zeile des ersten Arrays (fill_array) angibt, ob ein oder mehr als ein Defektbit für jede gespeicherte Adresse eines Speicherworts vorliegen,
Differenzelemente (IO 0, IO 1, IO 2, IO 3) gebildet werden, wobei diese Differenzelemente (IO 0, IO 1, IO 2, IO 3) für jede IO des Speichers die Differenz zwischen dem Referenzelement und einer Spalte in dem ersten Array (shift_array) entsprechend der jeweiligen IO des Speichers angeben,
das Differenzelement (IO 3) mit der maximalen Anzahl von Nulleintragswerten ausgewählt wird, um anzugeben, welche IO des Speichers durch die redundante IO des Speichers zu ersetzen ist.

**5.** Chip nach Anspruch 4, wobei
der On-Chip-Diagnoseblock zur Speicherreparatur so konfiguriert ist, dass das gewählte Differenzelement (IO 3) angibt, welche Adressen von Speicherwörtern in den redundanten Wortregistern außerhalb des Speichers zu speichern sind.

**6.** Chip nach Anspruch 2 bis 5, wobei
die Größe des ersten Arrays (fill_array) folgendermaßen definiert ist:

Anzahl der Zeilen des ersten Arrays (fill_array) = 2* (Anzahl der redundanten Wortregister) + Anzahl redundanter IO des Speichers.

**7.** Chip nach Anspruch 2 bis 6, wobei
die Größe des zweiten Arrays (shift_array) folgendermaßen definiert ist:

Anzahl der Zeilen des zweiten Arrays (shift_array) = Anzahl der redundanten Wortregister + Anzahl redundanter IO des Speichers.

**8.** On-Chip-Diagnoseverfahren zur Speicherreparatur, wobei der Speicher eine Vielzahl von Gruppen von Speicherzellen umfasst und jede Gruppe mit einer IO des Speichers assoziiert ist, wobei der Speicher ferner eine redundante Gruppe von Speicherzellen umfasst, die mit einer redundanten IO des Speichers assoziiert ist, wobei solche IO-Redundanz die einzige Redundanz innerhalb des Speichers ist, und der Chip einen On-Chip-Diagnoseblock und eine Vielzahl von redundanten Wortregistern außerhalb des Speichers umfasst, mit den folgenden Schritten:

- Speichern von Defektinformationen in dem On-Chip-Diagnoseblock während eines BIST-Durchlaufs und dann
- führt der On-Chip-Diagnoseblock eine Enddiagnose auf dem Chip auf der Basis einer Analyse der Informationen durch, um sowohl IO- als auch Wortregister-Reparaturlösungen zu evaluieren.

**9.** On-Chip-Diagnoseverfahren nach Anspruch 8, ferner mit dem folgenden Schritt:

Verwenden eines in dem On-Chip-Diagnoseblock zur Speicherreparatur beinhalteten zweiten Arrays (shift_array), um das Füllen eines in dem On-Chip-Diagnoseblock zur Speicherreparatur beinhalteten ersten Arrays (fill_array) während des BIST zu steuern.

**10.** On-Chip-Diagnoseverfahren nach Anspruch 9, ferner mit dem folgenden Schritt:

Analysieren des ersten Arrays (fill_array), um die Enddiagnose durchzuführen.

**11.** On-Chip-Diagnoseverfahren nach Anspruch 10, ferner mit den folgenden Schritten:

Erzeugen eines Referenzelements aus dem ersten Array (fill_array), wobei dieses Referenzelement für jede Zeile des ersten Arrays (fill_array) angibt, ob ein oder mehr als ein Defektbit für jede gespeicherte Adresse eines Speicherworts vorliegen,
Erzeugen von Differenzelementen (IO 0, IO 1, IO 2, IO 3), wobei diese Differenzelemente (IO 0, IO 1, IO 2, IO 3) für jede IO des Speichers die Differenz zwischen dem Referenzelement und einer Spalte in dem ersten Array (shift_array) entsprechend der jeweiligen IO des Speichers angeben, und
Auswählen des Differenzelements (IO 3) mit der maximalen Anzahl von Nulleintragswerten, um anzugeben, welche IO des Speichers durch die redundante IO des Speichers zu ersetzen ist.

**12.** On-Chip-Diagnoseverfahren nach Anspruch 11, ferner mit dem folgenden Schritt:

Entscheiden, welche Adressen von Speicherwörtern in den Wortregistern außerhalb des Speichers zu speichern sind, auf der Basis des gewählten Differenzelements (IO 3).

**13.** On-Chip-Diagnoseverfahren nach Anspruch 8 bis 12, wobei nur ein BIST-Durchlauf durchgeführt wird.

**Revendications**

**1.** Puce comprenant une mémoire et un bloc de diagnostic sur puce pour réparer une mémoire, la mémoire comprenant une pluralité de groupes de cellules de mémoire, chaque groupe étant associé à une IO de la mémoire, la puce comprenant en outre une pluralité de registres de mots redondants extérieurement à la mémoire ; **caractérisée en ce que** :

- la mémoire comprend en outre un groupe redondant de cellules de mémoire associé à une IO redondante de la mémoire, une redondance IO de ce genre étant la seule redondance intérieure à la mémoire, et
- le bloc de diagnostic sur puce est conçu pour mémoriser, pendant une exécution BIST, une information de défaut et pour effectuer un diagnostic final sur puce, basé sur une analyse de cette information, pour évaluer à la fois des solutions de réparation de IO et de registres de mot.

**2.** Puce suivant la revendication 1, dans laquelle le bloc de diagnostic sur puce pour réparer une mémoire, comprend un premier tableau (fill_array) et un deuxième tableau (shift_array) sur puce et est configuré pour utiliser le deuxième tableau (shift_array), pour commander le remplissage du premier tableau (fill_array) pendant le BIST.

**3.** Puce suivant la revendication 2, dans laquelle le bloc de diagnostic sur puce pour réparer une mémoire est conçu pour effectuer le diagnostic final après une analyse du premier tableau (fill_array).

**4.** Puce suivant la revendication 3, dans laquelle le bloc de diagnostic sur puce pour réparer une mémoire est configuré de manière à ce que, à la fin du BIST un élément de référence soit formé à partir du premier tableau (fill_array), cet élément de référence indiquant pour chaque ligne du premier tableau (fill_array) s'il y a un ou plusieurs bits de défaut pour chaque adresse mémorisée d'un mot de mémoire, de manière à former des éléments (10 0, IO 1, IO 2, IO 3) de différence, ces éléments (10 0, IO 1, IO 2, IO 3) de différence indiquant, pour chaque IO de la mémoire, la différence entre l'élément de référence et une colonne du premier tableau (shift-array) correspondant à la IO respective de la mémoire, de manière à ce que l'élément (10 3) de différence ayant le nombre maximum de valeurs d'entrée 0 soit choisi, pour indiquer celle des IO de la mémoire qui doit être remplacée par la IO redondante de la mémoire.

**5.** Puce suivant la revendication 4, dans laquelle le bloc de diagnostic sur puce pour réparer une mémoire est configuré de manière à ce que l'élément IO 3 de différence choisi indique celles des adresses de mots de mémoire, qui doivent être mémorisées à l'intérieur des registres de mot redondants extérieurement à la mémoire.

**6.** Puce suivant les revendications 2 à 5, dans laquelle la dimension du premier tableau (fill_array) est définie par :

nombre de lignes du premier tableau (fill_array) = 2* (nombre de registres de mot redondants) + nombre de IO de la mémoire.

**7.** Puce suivant les revendications 2 à 6, dans laquelle la dimension du second tableau (shift_array) est définie par :

nombre de lignes du second tableau (shift_array) = nombre de registres de mot redondants + nombre de IO de la mémoire.

**8.** Procédé de diagnostic sur puce pour réparer une mémoire, la mémoire comprenant une pluralité de groupes de cellules de mémoire, chaque groupe étant associé à une IO de la mémoire comprenant en outre un groupe redondant de cellules de mémoire associé à une IO redondante de la mémoire, une redondance IO de ce genre étant la seule redondance interne à la mémoire, et la puce comprend un bloc de diagnostic sur puce et une pluralité de registres de mot redondants, extérieurement à la mémoire, comprenant les stades :

- pendant l'exécution BIST, on mémorise une information de défaut dans le bloc de diagnostic sur puce, puis
- le bloc de diagnostic sur puce effectue un diagnostic final sur puce, sur la base d'une analyse de l'information, pour évaluer, à la fois, des solutions de réparation de IO et de registres de mot.

9. Procédé de diagnostic sur puce suivant la revendication 8, dans lequel en outre :

on utilise un deuxième tableau (shift_array) compris dans le bloc de diagnostic sur puce pour réparer une mémoire, pour commander le remplissage du premier tableau (fill_array) compris dans le bloc de diagnostic sur puce pour réparer une mémoire pendant le BIST.

10. Procédé de diagnostic sur puce suivant la revendication 9, dans lequel en outre :

on analyse le premier tableau (fill_array), pour effectuer le diagnostic final.

11. Procédé de diagnostic sur puce suivant la revendication 10, dans lequel en outre :

on produit un élément de référence à partir du premier tableau (fill_array), cet élément de référence indiquant pour chaque ligne du premier tableau (fill_array), s'il y a un ou plus d'un bit de défaut, pour chaque adresse mémorisée d'un mot de mémoire,
on produit des éléments (10 0, IO 1, IO 2, IO 3) de différence, ces éléments (10 0, IO 1, IO 2, IO 3) de différence indiquant pour chaque IO de la mémoire, la différence entre l'élément de référence et une colonne dans le premier tableau (shift_array) correspondant à la IO respective de la mémoire, et
on choisit l'élément (10 3) de différence ayant un nombre maximum de valeurs d'entrée zéro, pour indiquer la IO de la mémoire à remplacer par la IO redondante de la mémoire.

12. Procédé de diagnostic sur puce suivant la revendication 11, dans lequel en outre :

on décide des adresses de mots de mémoire à mémoriser à l'intérieur des registres de mot extérieurement à la mémoire, sur la base de l'élément (IO 3) de différence choisie.

13. Procédé de diagnostic sur puce suivant les revendications 8 à 12, dans lequel on effectue seulement une seule exécution BIST.

FIG 1

Memory 4kx32

Internal redundancy

IOR

4kx32

WL 511

512

WL 0

IO 31

32

IO 0

External redundancy

Redundant Register Address

Redundant Register Data

RRA1

RRA2

RRA3

RRD1

RRD2

RRD3

0

31

0

12

FIG 2

# FIG 3

| | flag | addr | IO 31 | IO 30 | fill_array | IO 4 | IO 3 | IO 2 | IO 1 | IO 0 |
|---|---|---|---|---|---|---|---|---|---|---|
| L 1 | | | | | · · · · · · · · · · · · · · · · · | | | | | |
| L 2 | | | | | | | | | | |
| L 3 | | | | | | | | | | |
| L 4 | | | | | | | | | | |
| L 5 | | | | | | | | | | |
| L 6 | | | | | | | | | | |
| L 7 | | | | | · · · · · · · · · · · · · · · · · | | | | | |

| | IO 31 | IO 30 | shift_array | IO 4 | IO 3 | IO 2 | IO 1 | IO 0 |
|---|---|---|---|---|---|---|---|---|
| L 1 | | | · · · · · · · · · · · · · · · · · | | | | | |
| L 2 | | | | | | | | |
| L 3 | | | | | | | | |
| L 4 | | | · · · · · · · · · · · · · · · · · | | | | | |

EP 1 517 334 B1

# FIG 4

Defect 1: addr 1 with 1 defect bit

WL 7
WL 6
WL 5
WL 4
WL 3
WL 2
WL 1

IO 31     IO 3     IO 2     IO 1     IO 0

**fill_array**

| | flag | addr | IO31 | IO30 | | IO 4 | IO 3 | IO 2 | IO 1 | IO 0 |
|---|---|---|---|---|---|---|---|---|---|---|
| L 1 | 1 | ADDR1 | | | ----------------- | | 1 | | | |
| L 2 | | | | | | | | | | |
| L 3 | | | | | | | | | | |
| L 4 | | | | | | | | | | |
| L 5 | | | | | | | | | | |
| L 6 | | | | | | | | | | |
| L 7 | | | | | ----------------- | | | | | |

**shift_array**

| | IO31 | IO30 | | IO 4 | IO 3 | IO 2 | IO 1 | IO 0 |
|---|---|---|---|---|---|---|---|---|
| L 1 | | | ---------------- | | 1 | | | |
| L 2 | | | | | | | | |
| L 3 | | | | | | | | |
| L 4 | | | ---------------- | | | | | |

EP 1 517 334 B1

**FIG 5**

Defect 2: addr 2 with 3 defects bits

WL 7
WL 6
WL 5
WL 4
WL 3
WL 2
WL 1

IO 31    IO 3    IO 2    IO 1    IO 0

fill_array

| | flag | addr | IO 31 | IO 30 | ............... | IO 4 | IO 3 | IO 2 | IO 1 | IO 0 |
|---|---|---|---|---|---|---|---|---|---|---|
| L 1 | 1 | ADDR1 | | | | | 1 | | | |
| L 2 | 1 | ADDR2 | | | | | 1 | 1 | | 1 |
| L 3 | | | | | | | | | | |
| L 4 | | | | | | | | | | |
| L 5 | | | | | | | | | | |
| L 6 | | | | | | | | | | |
| L 7 | | | | | ............... | | | | | |

shift_array

| | IO 31 | IO 30 | ............... | IO 4 | IO 3 | IO 2 | IO 1 | IO 0 |
|---|---|---|---|---|---|---|---|---|
| L 1 | | | ............... | | 1 | 1 | | 1 |
| L 2 | | | | | 1 | | | |
| L 3 | | | | | | | | |
| L 4 | | | ............... | | | | | |

EP 1 517 334 B1

# FIG 6

Defect 3: addr 3 with 4 defects bits

WL 7
WL 6
WL 5
WL 4
WL 3
WL 2
WL 1

IO 31    IO 3    IO 2    IO 1    IO 0

fill_array

| | flag | addr | IO 31 | IO 30 | | IO 4 | IO 3 | IO 2 | IO 1 | IO 0 |
|---|---|---|---|---|---|---|---|---|---|---|
| L 1 | 1 | ADDR1 | | | ----------------- | | 1 | | | |
| L 2 | 1 | ADDR2 | | | | | 1 | 1 | | 1 |
| L 3 | 1 | ADDR3 | | | | | 1 | 1 | 1 | 1 |
| L 4 | | | | | | | | | | |
| L 5 | | | | | | | | | | |
| L 6 | | | | | | | | | | |
| L 7 | | | | | ----------------- | | | | | |

shift_array

| | IO 31 | IO 30 | | IO 4 | IO 3 | IO 2 | IO 1 | IO 0 |
|---|---|---|---|---|---|---|---|---|
| L 1 | | | ----------------- | | 1 | 1 | 1 | 1 |
| L 2 | | | | | 1 | 1 | | 1 |
| L 3 | | | | | 1 | | | |
| L 4 | | | ----------------- | | | | | |

# FIG 7

Defect 4: addr 4 with 1 defect bit

fill_array

| | flag | addr | IO 31 | IO 30 | | IO 4 | IO 3 | IO 2 | IO 1 | IO 0 |
|---|---|---|---|---|---|---|---|---|---|---|
| L 1 | 1 | ADDR1 | | | ------------------- | | 1 | | | |
| L 2 | 1 | ADDR2 | | | | | 1 | 1 | | 1 |
| L 3 | 1 | ADDR3 | | | | | 1 | 1 | 1 | 1 |
| L 4 | 1 | ADDR4 | | | | | 1 | | | |
| L 5 | | | | | | | | | | |
| L 6 | | | | | | | | | | |
| L 7 | | | | | ------------------- | | | | | |

shift_array

| | IO 31 | IO 30 | | IO 4 | IO 3 | IO 2 | IO 1 | IO 0 |
|---|---|---|---|---|---|---|---|---|
| L 1 | | | ------------------- | | 1 | 1 | 1 | 1 |
| L 2 | | | | | 1 | 1 | | 1 |
| L 3 | | | | | 1 | | | |
| L 4 | | | ------------------- | | 1 | | | |

## FIG 8

Defect 5: addr 5 with 1 defect bit (on IO 3 → no fill because shift_array(L4) on IO 3 is already filled)

fill_array

| | flag | addr | IO 31 | IO 30 | | IO 4 | IO 3 | IO 2 | IO 1 | IO 0 |
|---|---|---|---|---|---|---|---|---|---|---|
| L 1 | 1 | ADDR1 | | | ----------------- | | 1 | | | |
| L 2 | 1 | ADDR2 | | | | | 1 | 1 | | 1 |
| L 3 | 1 | ADDR3 | | | | | 1 | 1 | 1 | 1 |
| L 4 | 1 | ADDR4 | | | | | 1 | | | |
| L 5 | | | | | | | | | | |
| L 6 | | | | | | | | | | |
| L 7 | | | | | ----------------- | | | | | |

shift_array

| | IO 31 | IO 30 | | IO 4 | IO 3 | IO 2 | IO 1 | IO 0 |
|---|---|---|---|---|---|---|---|---|
| L 1 | | | ----------------- | | 1 | 1 | 1 | 1 |
| L 2 | | | | | 1 | 1 | | 1 |
| L 3 | | | | | 1 | | | |
| L 4 | | | ----------------- | | 1 | | | |

EP 1 517 334 B1

**FIG 9**    Defect 6: addr 6 with 1 defect bit (on IO 3 ──▶ no fill of the two arrays)

|  | flag | addr | IO 31 | IO 30 | | fill_array | | IO 4 | IO 3 | IO 2 | IO 1 | IO 0 |
|---|---|---|---|---|---|---|---|---|---|---|---|---|
| L 1 | 1 | ADDR1 | | | | ----------------- | | | 1 | | | |
| L 2 | 1 | ADDR2 | | | | | | | 1 | 1 | | 1 |
| L 3 | 1 | ADDR3 | | | | | | | 1 | 1 | 1 | 1 |
| L 4 | 1 | ADDR4 | | | | | | | 1 | | | |
| L 5 | | | | | | | | | | | | |
| L 6 | | | | | | | | | | | | |
| L 7 | | | | | | ----------------- | | | | | | |

|  | IO 31 | IO 30 | | shift_array | | IO 4 | IO 3 | IO 2 | IO 1 | IO 0 |
|---|---|---|---|---|---|---|---|---|---|---|
| L 1 | | | | ----------------- | | | 1 | 1 | 1 | 1 |
| L 2 | | | | | | | 1 | 1 | | 1 |
| L 3 | | | | | | | 1 | | | |
| L 4 | | | | ----------------- | | | 1 | | | |

EP 1 517 334 B1

FIG 10

Defect 7: addr 7 with 1 defect bit (on IO 3 → no fill of the two arrays)

FIG 11

Defect 8: addr 12 with 1 defect bit

## FIG 12

Defect 9: addr 1 with 1 defect bit (on IO 3 ⟶ the two arrays are unchanged)

fill_array

| | flag | addr | IO 31 | IO 30 | | IO 4 | IO 3 | IO 2 | IO 1 | IO 0 |
|---|---|---|---|---|---|---|---|---|---|---|
| L 1 | 1 | ADDR1 | | | ----------------- | | 1 | | | |
| L 2 | 1 | ADDR2 | | | | | 1 | 1 | | 1 |
| L 3 | 1 | ADDR3 | | | | | 1 | 1 | 1 | 1 |
| L 4 | 1 | ADDR4 | | | | | 1 | | | |
| L 5 | 1 | ADDR12 | | | | | | | | 1 |
| L 6 | | | | | | | | | | |
| L 7 | | | | | ----------------- | | | | | |

shift_array

| | IO 31 | IO 30 | | IO 4 | IO 3 | IO 2 | IO 1 | IO 0 |
|---|---|---|---|---|---|---|---|---|
| L 1 | | | ------------------ | | 1 | 1 | 1 | 1 |
| L 2 | | | | | 1 | 1 | | 1 |
| L 3 | | | | | 1 | | | 1 |
| L 4 | | | ------------------ | | 1 | | | |

# FIG 13

Defect 10: addr 2 with 1 defect bit (addr 2 is already stored)

WL 7
WL 6
WL 5
WL 4
WL 3
WL 2
WL 1

IO 31   IO 3   IO 2   IO 1   IO 0

fill_array

| | flag | addr | IO 31 | IO 30 | ... | IO 4 | IO 3 | IO 2 | IO 1 | IO 0 |
|---|---|---|---|---|---|---|---|---|---|---|
| L 1 | 1 | ADDR1 | | | | | 1 | | | |
| L 2 | 1 | ADDR2 | | | | | 1 | 1 | 1 | 1 |
| L 3 | 1 | ADDR3 | | | | | 1 | 1 | 1 | 1 |
| L 4 | 1 | ADDR4 | | | | | 1 | | | |
| L 5 | 1 | ADDR12 | | | | | | | | 1 |
| L 6 | | | | | | | | | | |
| L 7 | | | | | ... | | | | | |

shift_array

| | IO 31 | IO 30 | ... | IO 4 | IO 3 | IO 2 | IO 1 | IO 0 |
|---|---|---|---|---|---|---|---|---|
| L 1 | | | ... | | 1 | 1 | 1 | 1 |
| L 2 | | | | | 1 | 1 | 1 | 1 |
| L 3 | | | | | 1 | | | 1 |
| L 4 | | | ... | | 1 | | | |

FIG 14

FIG 15

FIG 16

## FIG 17

```
        ┌──────────────────┐
        │  Start the BIST  │
        └──────────────────┘
                 │
                 ▼ ◄─────────────┐
        ┌──────────────────┐     │
        │       BIST       │     │
        └──────────────────┘     │
                 │               │
                 ▼               │ n
           ◇ BIST is done? ◇ ────┘
                 │ y
                 ▼
        ┌──────────────────┐
        │    diagnostic    │
        └──────────────────┘
                 │
                 ▼
           ◇ Fault detected ◇ ──n──►  ( End Test )
                 │ y
                 ▼
           ◇ Memory reparable ◇ ──n──► ┌──────────────────┐
                 │ y                    │   Flag memory    │
                 ▼                      │   unreparable    │
        ┌──────────────────┐           └──────────────────┘
        │ Activate redundancy │                 │
        └──────────────────┘                    │
                 │◄──────────────────────────────┘
                 ▼
           ( End Test )
```

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- EP 03002698 A


**Non-patent literature cited in the description**

- **Akira Tanabe et al.** A 30-ns 64-Mb DRAM with Built-in Self-Test and Self-Repair Function. *IEEE Journal of Solid-State Circuits,* 01 November 1992